(19) 

**Europäisches Patentamt**

**European Patent Office**

**Office européen des brevets**

(11) **EP 4 765 631 A1**

(12) **EUROPEAN PATENT APPLICATION**

(43) Date of publication:
**24.06.2026 Bulletin 2026/26**

(21) Application number: **25224372.0**

(22) Date of filing: **17.12.2025**

(51) International Patent Classification (IPC):
**H03F 1/30** (2006.01)    **H03F 3/45** (2006.01)
**H03F 1/02** (2006.01)    **G05F 3/26** (2006.01)
**H03F 1/22** (2006.01)    **H03F 3/19** (2006.01)

(52) Cooperative Patent Classification (CPC):
**H03F 3/45188; G05F 3/262; H03F 1/0205;**
**H03F 1/223; H03F 1/301; H03F 3/19;**
H03F 2200/18; H03F 2200/447

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **18.12.2024 US 202418985174**

(71) Applicant: **Avago Technologies International**
**Sales**
**Pte. Limited**
**Singapore 768923 (SG)**

(72) Inventors:
• **Kong, Derui**
  **Irvine, 92620 (US)**
• **Wang, Jingguang**
  **Laguna Niguel, 92677 (US)**
• **Cui, Delong**
  **Tustin, 92782 (US)**
• **Cao, Jun**
  **Irvine, 92620 (US)**

(74) Representative: **Dilg, Haeusler, Schindelmann**
**Patentanwaltsgesellschaft mbH**
**Leonrodstraße 58**
**80636 München (DE)**

(54) **ADAPTIVE CASCODE GATE BIAS GENERATION CIRCUIT**

(57)    A circuit including a first resistor (R21), a second resistor (R22), a current source (211) and a transistor (QP23). The first resistor (R21) is between a voltage rail and a drive interconnect. The drive interconnect and the voltage rail are electrically connected to the first resistor (R21). The second resistor (R22) is between the drive interconnect and ground. Ground and the drive interconnect are electrically connected to the second resistor (R22). The current source (211) is between the voltage rail and the drive interconnect. The drive interconnect and the voltage rail are electrically connected to the current source (211). The transistor (QP23) is between the drive interconnect and a sink interconnect. The drive interconnect and the sink interconnect are electrically connected to the transistor (QP23).

FIG. 2

EP 4 765 631 A1

**Description**

**BACKGROUND**

High-Swing Serial-Link Transmitters are specialized circuits used in high-speed communication systems. They are designed to transmit data over a serial link with a wide output voltage swing. To improve signal-to-noise ratio (SNR) by minimizing distortion over long distances or lossy channels, High-Swing Serial-Link Transmitters implement differential signaling, pre-emphasis, and impedance matching to enhance signal integrity.

**BRIEF DESCRIPTION OF DRAWINGS**

The accompanying drawings, which are incorporated in and form a part of this specification, illustrate examples of the disclosure and, together with the description, explain principles of the examples.

FIG. 1 illustrates an exemplary High-Swing Serial-Link Transmitter, in accordance with one or more embodiments of the disclosure.

FIG. 2 illustrates an exemplary gate bias generator and output driver, in accordance with one or more embodiments of the disclosure.

FIG. 3 illustrates an exemplary gate bias generator, in accordance with one or more embodiments of the disclosure.

FIG. 4 illustrates an exemplary output driver, in accordance with one or more embodiments of the disclosure.

FIG. 5 illustrates an exemplary gate bias generator, in accordance with one or more embodiments of the disclosure.

FIG. 6 illustrates an exemplary gate bias generator, in accordance with one or more embodiments of the disclosure.

FIG. 7 illustrates an exemplary comparison, in accordance with one or more embodiments of the disclosure.

FIG. 8 illustrates an exemplary comparison, in accordance with one or more embodiments of the disclosure.

FIG. 9 illustrates an exemplary comparison, in accordance with one or more embodiments of the disclosure.

In the drawings, like reference symbols and numerals indicate the same or similar components. Like elements in the various figures are denoted by like reference symbols and numerals for consistency. Unless otherwise indicated, like elements and method steps are referred to with like reference numerals.

**DETAILED DESCRIPTION OF THE INVENTION**

The following describes technical solutions in this specification with reference to the accompanying drawings. Exemplary embodiments are described in detail with reference to the accompanying drawings.

The terminology used herein is for describing various examples only, and is not to be used to limit the disclosure. Unless otherwise defined, all terms, including technical and scientific terms, used herein have the same meaning as commonly understood by one of ordinary skill in the art to which this disclosure pertains and after an understanding of the disclosure of this application.

Terms, such as those defined in commonly used dictionaries, are to be interpreted as having a meaning that is consistent with their meaning in the context of the relevant art and the disclosure of this application. Although the present technology has been described by referring to certain examples, workers skilled in the art will recognize that changes may be made in form and detail without departing from the scope of the discussion.

High swing transmission providing higher than 1.5V peak-to-peak swing is often needed in long-distance serial links applications where channel loss are significant. Typically, an output driver of a High-Swing Serial-Link Transmitter usually contains an Output Cascode to protect the reliability of core devices and also to improve transmission linearity. Gate biasing of the Output Cascode is critical for meeting the linearity specification and for maintaining High-Swing Serial-Link Transmitter reliability. Conventional cascode gate biasing techniques are either sensitive to process and temperature corners, or sensitive to resistor corner and input bias current. Accordingly, there is a need in the art for an improved gate bias generator.

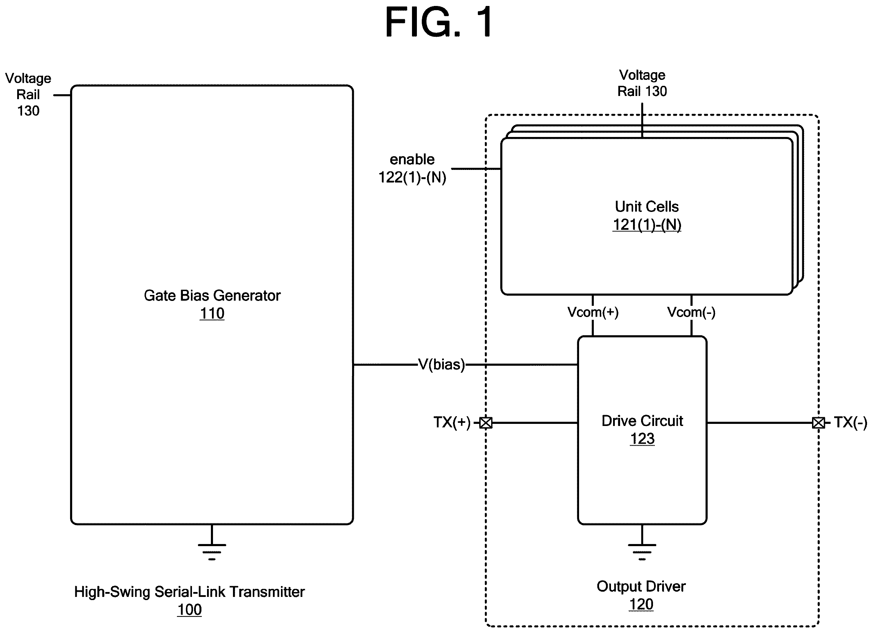

Referring to FIG. 1, an example High-Swing Serial-Link Transmitter 100 is illustrated. High-Swing Serial-Link Transmitter 100 may include gate bias generator 110, output driver 120 and voltage rail 130. Voltage rail 130 is a wiring network that distributes a supply voltage VDD thought High-Swing Serial-Link Transmitter 100. Supply voltage VDD is an electrical potential higher than ground. Ground serves as a zero-voltage reference point in High-Swing Serial-Link Transmitter 100. Those skilled in the art will appreciate that there may be additional components in High-Swing Serial-Link Transmitter 100.

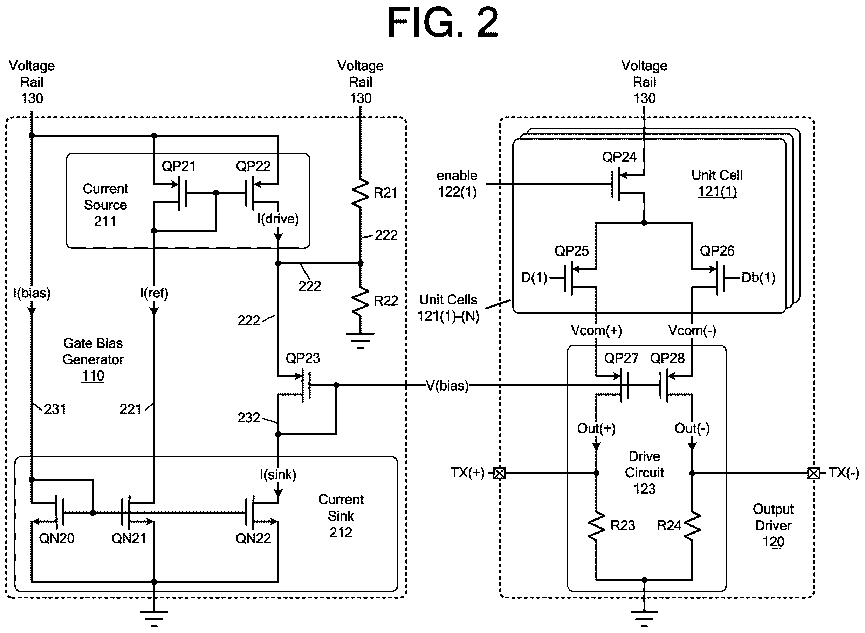

Turning now to FIG. 2, gate bias generator 110 is circuitry designed to generate a gate bias voltage V(bias). As such, gate bias generator 110 may happen to be an apparatus. Gate bias generator 110 may include current source 211, transistor QP23 and current sink 212. Also included in gate bias generator 110 are resistors R21 and R22. Those skilled in the art will appreciate that there may be additional components in gate bias generator 110.

Current source 211 is a current mirror that includes reference transistor QP21 and mirror transistor QP22. The gates of transistors QP21 and QP22 are commonly connected. Similarly, the sources of transistors QP21 and QP22 are also commonly connected.

Current source 211 may convert a supply voltage VDD from voltage rail 130 into a stable reference current I(ref). Current source 211 may push reference current I(ref) onto a reference interconnect 221. Reference interconnect 221 is wiring in gate bias generator 110. For instance, having the drain and gate of transistor QP21 shorted together, transistor QP21 is shown to be in a diode-connected configuration so that reference current I(ref) from voltage rail 130 may flow through transistor QP21.

Due to the fact that current source 211 is a current mirror, mirror transistor QP22 may replicate or scale reference current I(ref) so as to push a drive current I(drive) onto drive interconnect 222.

In such examples, drive current I(drive) may happen to be proportional to the reference current I(ref). Drive interconnect 222 is wiring in gate bias generator 110. As illustrated in FIG. 2, a portion of drive interconnect 222 extends from mirror transistor QP22 whereas another portion of drive interconnect 222 extends from resistors R21, R22.

Transistor QP23 is shown to be in a diode-connected transistor having the drain and gate of transistor QP23 shorted together. As a diode-connected transistor, transistor QP23 may behave like a diode. For instance, the source of transistor QP23 may server as an anode of a diode with a cathode of the diode being the drain and gate of transistor QP23. Behaving like a diode, current may flow through transistor QP23 in one direction from the source of transistor QP23 to the drain of transistor QP23.

Current sink 212 is a current mirror that includes bias transistor QN20 and mirror transistors QN21, QN22. The gates of transistors QN20, QN21, QN22 are commonly connected. Similarly, the sources of transistors QN20, QN21, QN22 are also commonly connected. Current sink 212 may draw a fixed amount of bias current I(bias) to ground in a bias interconnect 231. Bias interconnect 231 is wiring in gate bias generator 110, as illustrated in FIG. 2. For instance, having the drain and gate of transistor QN20 shorted together, transistor QN20 is shown to be in a diode-connected configuration so that the bias current I(bias) from voltage rail 130 may flow to ground through transistor QN20.

Mirror transistor QN21 may replicate or scale bias current I(bias) so as to pull a fixed amount of reference current I(ref) in reference interconnect 221 to ground. Being that mirror transistor QN21 and reference transistor QP21 are electrically connected directly in series in the example of FIG. 2, an amount of reference current I(ref) from reference transistor QP21 may flow along reference interconnect 221 to mirror transistor QN21.

Reference transistor QP21 may attempt to push a specific amount of reference current I(ref) from voltage rail 130 onto reference interconnect 221 whereas mirror transistor QN21 may simultaneously attempt to pull a set amount of reference current I(ref) from reference interconnect 221 to ground. This push-pull dynamic between reference transistor QP21 and mirror transistor QN21 ensures that the combination of reference transistor QP21 in series with mirror transistor QN21 may regulate the amount of reference current I(ref) in the reference interconnect 221. For example, in some implementations where mirror transistor QN21 pulls a lesser amount of reference current I(ref) from reference interconnect 221 than reference transistor QP21 may push onto reference interconnect 221, mirror transistor QN21 may limit the amount of reference current I(ref) flowing in reference interconnect 221 to an amount that varies proportionally with the bias current I(bias). In other implementations where mirror transistor QN21 may pull a greater amount of reference current I(ref) from reference interconnect 221 than reference transistor QP21 pushes onto reference interconnect 221, reference transistor QP21 may limit the amount of reference current I(ref) flowing in reference interconnect 221 to an amount pulled from voltage rail 130.

Mirror transistor QN22 may replicate or scale bias current I(bias) so as to pull a fixed amount of sink current I(sink) in sink interconnect 232 from the drain of transistor QP23 to ground. Sink interconnect 232 is wiring in gate bias generator 110, as illustrated in FIG. 2.

Transistor QP23 is electrically connected directly in series with mirror transistor QP22 and mirror transistor QN22 in the example of FIG. 2. Mirror transistor QP22 may replicate or scale reference current I(ref) to create a drive current I(drive) in drive interconnect 222 of gate bias generator 110. In such examples, drive current I(drive) may happen to be proportional to the reference current I(ref). Mirror transistor QN22 may replicate or scale bias current I(bias) to create a sink current I(sink) in sink interconnect 232 of gate bias generator 110. In such examples, sink current I(sink) may happen to be proportional to the bias current I(bias).

Mirror transistor QP22 may attempt to push a specific amount of drive current I(drive) from voltage rail 130 onto drive interconnect 222 whereas mirror transistor QN22 may simultaneously attempt to pull a set amount of sink current I(sink) from sink interconnect 232 to ground. This push-pull dynamic between mirror transistor QP22 and mirror transistor QN22 ensures that the combination of mirror transistor QP22 in series with mirror transistor QN22 may regulate the amount of current that may flow through transistor QP23 from the source of transistor QP23 to the drain of transistor QP23. For example, in some implementations where mirror transistor QN22 pulls a lesser amount of sink current I(sink) from sink interconnect 232 than mirror transistor QP22 may push onto drive interconnect 222, mirror transistor QN22 may limit the current that may flow through transistor QP23 to an amount that varies proportionally with the bias current I(bias). In other implementations where mirror transistor QN22 may pull a greater amount of sink current I(sink) from sink interconnect 232 than mirror transistor QP22 pushes onto drive interconnect 222, mirror transistor QP22 may limit the amount of current that may flow through transistor QP23 to an amount of drive current I(drive) pulled from voltage rail 130.

Also included in gate bias generator 110 are resistors R21, R22. Resistor R21 is a passive electronic component whose resistance value is adjustable manually and/or electronically. Resistor R22 is another passive electronic component whose resistance value is adjustable manually and/or electronically. Resistance values for resistors R21 and R22 are adjustable independently from one another. Resistors R21 and R22 in gate bias generator 110 may exist as a resistive voltage divider circuit with resistor R21 being electrically connected directly to voltage rail 130 and resistor R22 being electrically connected directly to resistor R21 and ground.

In the example of FIG. 2, transistors QP21, QP22, QP23 are of a same conductivity-type. For instance, current source 211 may exist as a PMOS current source having P-type transistors QP21, QP22. Transistor QP23 is depicted as a PMOS diode-connected transistor. Transistors QN21, QN22, QN23 are of a same conductivity-type. Current sink 212 is depicted as an NMOS current sink having N-type transistors QN20, QN21, QN22. Those skilled in the art will appreciate that the conductivity-type for transistors QP21, QP22, QP23 is opposite to the conductivity-type for transistors QN20, QN21, QN22.

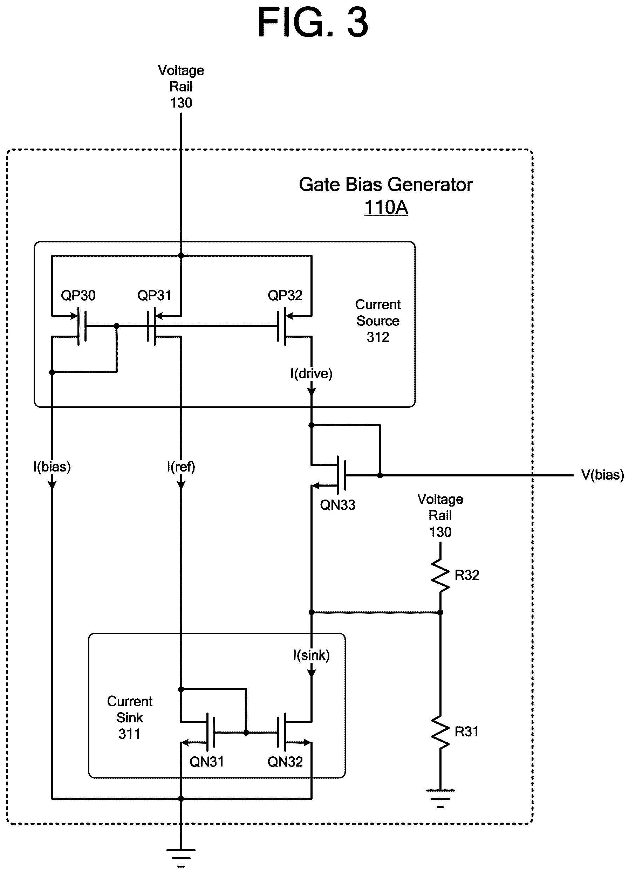

In comparison with the example of FIG. 2, gate bias generator 110A is illustrated in FIG. 3. Gate bias generator 110A may include current sink 311, transistor QN33 and current source 312. Also included in gate bias generator 110A are resistors R31 and R32. Current sink 311 is depicted in FIG. 3 as a NMOS current sink having N-type transistors QN31, QN32, QN33. Current source 312 is depicted as an PMOS current source having P-type transistors QP30, QP31, QP32. Those skilled in the art will appreciate that there may be additional components in gate bias generator 110A.

Output driver 120 of High-Swing Serial-Link Transmitter 100 may drive a load. Referring to FIG. 2, output driver 120 may include a plurality of identical unit cells 121(1)-(N), with "N" being an integer. Unit cells 121(1)-(N) may be collectively referred to as "unit cells 121." Any one of the unit cells 121(1)-(N) may be individually referred to as "unit cell 121." Unit cells 121(1)-(N) are electrically connected in parallel with one another.

Each of the unit cells 121(1)-(N) may include P-type transistors QP24, QP25 and QP26. Enable signals may include enable 122(1)-(N). In the example of FIG. 2, unit cell 121(1) is one of the unit cells 121(1)-(N). Closure of transistor QP24 in unit cell 121(1) may activate unit cell 121(1). Likewise, opening transistor QP24 in unit cell 121(1) may deactivate unit cell 121(1). The number of unit cells 121 that are activated during any time period is a user-selectable parameter. In particular, enable 122(1) is one of the enable signals (enable 122(1)-(N)). The opening and closure of QP24 in unit cell 121(1) may occur in response to enable 122(1). For instance, enable 122(1) at a specific logic level may cause the closure of QP24. Conversely, enable 122(1) at another logic level may cause the opening of QP24.

Cascode transistors QP25, QP26 may form a differential pair of input devices in a common-source configuration. Cascode transistors QP25, QP26 may operate in a differential mode. By way of example, input D(1) is applied to the gate of cascode transistor QP25. Input Db(1) is applied to the gate of cascode transistor QP26. Input D(1) and input Db(1) may happen to be complementary signals (input Db(1) = NOT input D(1)). As complementary signals, one of the inputs D(1), Db(1) is logic high along with the other of the inputs D(1), Db(1) being logic low at any given time. As a result of inputs D(1), Db(1) being complementary signals, cascode transistors QP25, QP26 may drive either current I(+) or current I(-) at any given time. For instance, cascode transistor QP25 is non-conductive at any given time that cascode transistor QP26 is conductive. Likewise, cascode transistor QP25 is conductive at any given time that cascode transistor QP26 is non-conductive.

Output driver 120 may also include drive circuit 123. Drive circuit 123 may include load resistors R23, R24 and output transistors QP27, QP28. Output transistors QP27, QP28 may form a differential pair of output devices in a common-gate configuration. Referred to herein, "current swing" is the variation in the current flow as the input signal changes. Output transistors QP27, QP28 may reduce any swing in the common mode voltages Vcom(+), Vcom(-) so as to prevent cascode transistors QP25, QP26 in a unit cell 121 from seeing large voltage swings at the drains of cascode transistors QP25, QP26, which prevents device breakdown of unit cell 121 and also helps maintain the linearity of differential voltages TX(+), TX(-).

As illustrated in the example of FIG. 2, output transistors QP27, QP28 are electrically connected in series with cascode transistors QP25, QP26 and ground, respectively.

A gate of transistor QP23 is electrically connected directly to the gates of output transistors QP27, QP28.

Transistors QP27, QP28 may replicate or scale sink current I(sink) so as to respectively pull a fixed amount of output current out(+), out(-) from unit cell 121.

The drains of output transistors QP27, QP28 may serve as differential outputs. Drive circuit 123 may output differential voltages TX(+), TX(-) respectively from the drains of output transistors QP27, QP28. For instance, the output from drive circuit 123 is at the drains of output transistors QP27, QP28 where output transistors QP27, QP28 may convert the common mode voltages Vcom(+), Vcom(-) into the differential voltages TX(+), TX(-) respectively. The drain of transistor QP23 is electrically connected directly to the gates of output transistors QP27, QP28. Those skilled in the art will appreciate that there may be additional components in drive circuit 123.

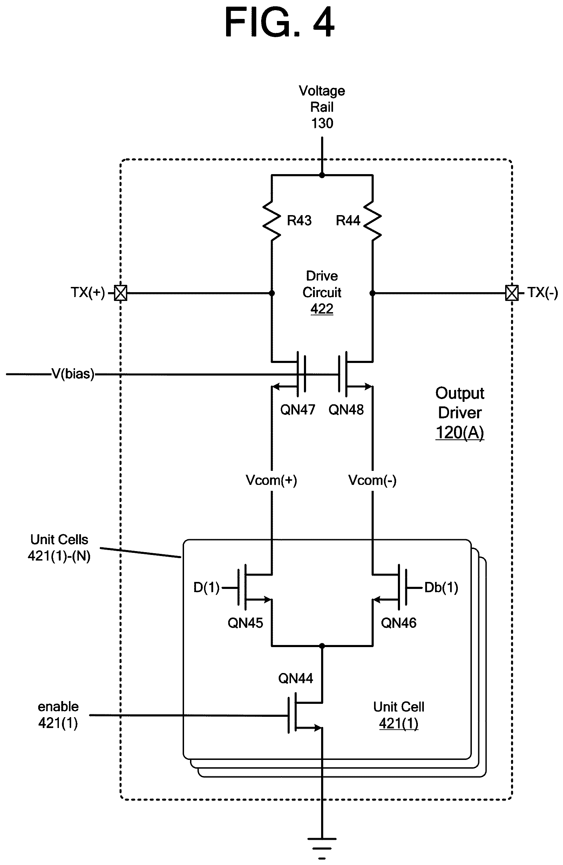

In the example of FIG. 2, those skilled in the art will appreciate that output driver 120 may exist as a P-type output driver 120 having P-type transistors QP24-QP28. In comparison with the example of FIG. 2, N-type output driver 120(A) is illustrated in FIG. 4. Output driver 120(A) may include resistors R43, R44 and N-type transistors QN44-QN48. Those skilled in the art will appreciate that there may be additional components in output driver 120(A).

Maintaining stable and consistent common mode voltages Vcom(+), Vcom(-) is critical for the linearity and reliability of output driver 120. For instance, a higher voltage level of common mode voltages Vcom(+), Vcom(-) may degrade the linearity of unit cells 121 whereas a lower voltage level of common mode voltages Vcom(+), Vcom(- ) may degrade the linearity of the drive circuit 123. In addition, the higher voltage level of common mode voltages Vcom(+), Vcom(-) may increase the drain-to-source voltage across each output transistor QP27, QP28 whereas the lower voltage level of common mode voltages Vcom(+), Vcom(-) may cause a voltage increase across unit cell 121 that risks device breakdown of unit cell 121. Therefore, an optimal voltage level of common mode voltages Vcom(+), Vcom(-), respectively, is essential for the overall linearity and reliability of High-Swing Serial-Link Transmitter 100.

To maintain optimal linearity and reliability of High-Swing Serial-Link Transmitter 100 during process and temperature fluctuations, it is crucial for common mode voltages Vcom(+), Vcom(-) to remain constant during the process and temperature fluctuations. Therefore, gate bias generator 110 must be configured in such a way that minimizes the effects of process and temperature variations.

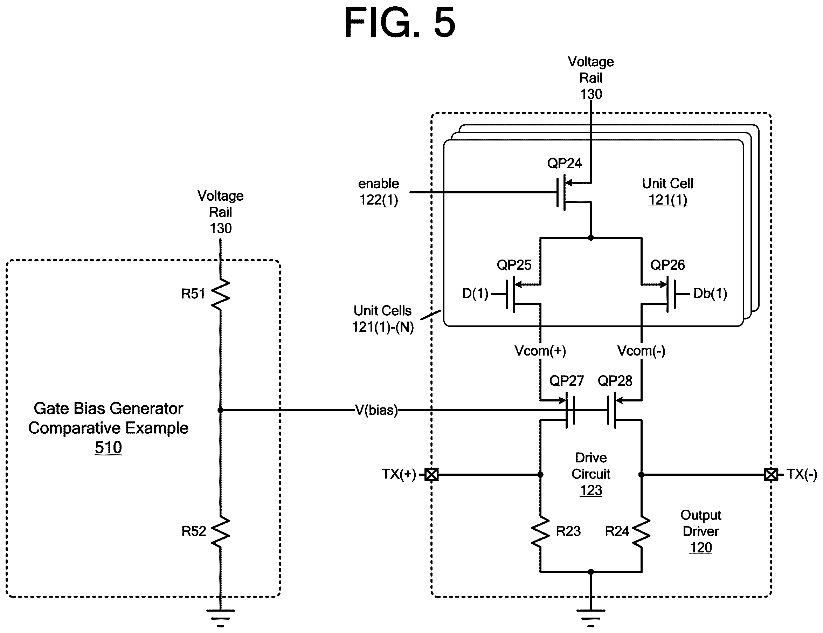

Turning now to FIG. 5, gate bias generator comparative example 510 is illustrated. Gate bias generator comparative example 510 may include resistors R51, R52. For simplicity and ease of understanding, the common mode voltages Vcom(+), Vcom(-) may each be identified as "V(com)" so that the gate bias voltage V(bias) in FIG. 5 is given by:

$$V(com) \; = \; \frac{VDD \cdot R51}{R51 + R52} + |VGS(casc)| \hspace{3cm} (1)$$

where,

"VGS(casc)" is the average gate-to-source voltage of transistors QP27 and QP28 As a drawback to gate bias generator comparative example 510, VGS(casc) in equation (1) may vary significantly during process and temperature fluctuations.

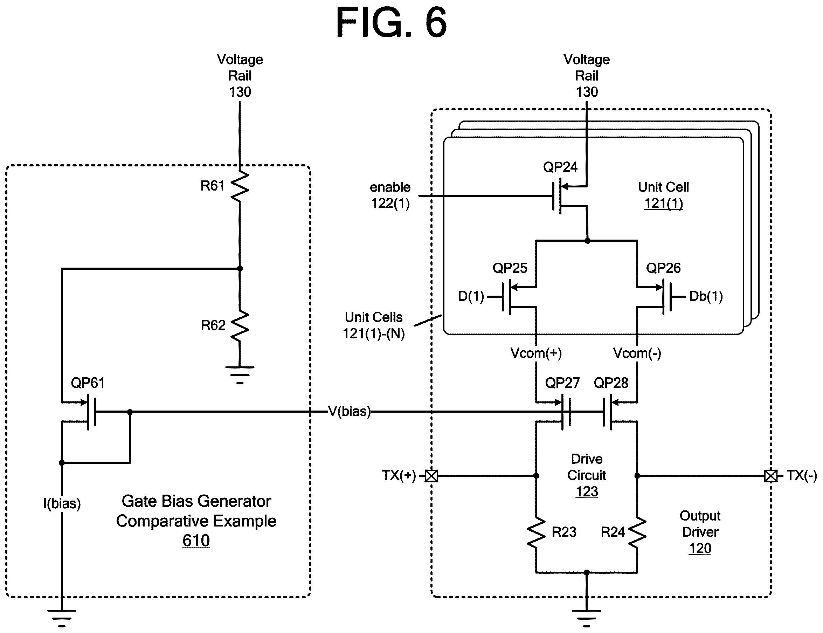

Turning now to FIG. 6, gate bias generator comparative example 610 is illustrated. Gate bias generator comparative example 610 may include transistor QP61 and resistors R61, R62. Transistor QP61 is shown to be in a diode-connected transistor having the drain and gate of transistor QP61 shorted together. For simplicity and ease of understanding, the common mode voltages Vcom(+), Vcom(-) may each be identified as "V(com)" so that the gate bias voltage V(bias) in FIG. 6 is given by:

$$V(com) = \frac{VDD \cdot R61}{R61 + R62} - I(bias) \frac{R61 \cdot R62}{R61 + R62} - |VGS(61)| + |VGS(casc)| \hspace{2cm} (2)$$

where,

"VGS(61)" is the gate-to-source voltage of transistor QP61
"VGS(casc)" is the average gate-to-source voltage of transistors QP27 and QP28

As a drawback to gate bias generator comparative example 610, VGS(casc) in equation (2) may vary significantly during process and temperature fluctuations. As implied by the $I(bias) \frac{R61 \cdot R62}{R61 + R62}$ term in equation (2), V(com) strongly depends on the bias current I(bias) and the values of resistors R61, R62. As a result, gate bias generator comparative example 610 is sensitive to the accuracy on the bias current I(bias) and resistor corner. Usually, the bias current I(bias) in the example of FIG. 6 is generated from a bandgap circuit. The bandgap circuit being typically located a significate distance from the output driver 120, may happen to generate many bias currents for all transmitter circuits and receiver circuits on an integrated circuit chip. Each bias current on the integrated circuit chip in the example of FIG. 6 may flow through many current mirrors. Generally, the value of bias current I(bias) in the example of FIG. 6 inaccurate unless complicated digital calibration is performed. The values for resistors R61, R62 can vary up to 20% across different resistor corners. Therefore, additional resistor calibration could be required in the example of FIG. 6 , which adds complexity to the design of gate bias generator comparative example 610.

As an alternative, gate bias generator 110 in FIG. 2 is in contrast with gate bias generator comparative example 510 and gate bias generator comparative example 610. Referring to FIG. 2, resistors R21 and R22 in gate bias generator 110 may exist as a resistive voltage divider circuit with resistor R21 being electrically connected directly to voltage rail 130 and resistor R22 being electrically connected directly to resistor R21 and ground. For simplicity and ease of understanding, the common mode voltages Vcom(+), Vcom(-) may each be identified as "V(com)" so that:

$$V(com) = \frac{VDD \cdot R21}{R21+R22} - (I(n) - I(p))\frac{R21 \cdot R22}{R21+R22} - |VGS(23)| + |VGS(casc)| \qquad (3)$$

where,

"VGS(23)" is the gate-to-source voltage of transistor QP23
"VGS(casc)" is the average gate-to-source voltage of transistors QP27 and QP28
"I(n)" is sink current I(sink)
"I(p)" is drive current I(drive)

Due to current source 211 and current sink 212 each being a current mirror, the values of drive current I(drive) and sink current I(sink) are nearly identical so that:

$$sink\ current\ I(sink) - drive\ current\ I(drive) \approx 0 \qquad (2)$$

The difference between the sink current I(sink) and drive current I(drive) is approximately 0, almost no current flows into the voltage divider R21, R22 from the source of transistor QP23. Since I(n) - I(p) is approximately 0, the $(I(n) - I(p))\frac{R21 \cdot R22}{R21+R22}$ term of gate voltage in equation (3) is nearly 0 resulting in a gate voltage that is independent of resistor corner, thus calibration of resistors R21 and R22 is unnecessary. Also in equation (1), VGS(23) and VGS(casc) may cancel one another since transistors QP23, QP27 and QP26 exhibit the same performance characteristics under similar operating conditions.

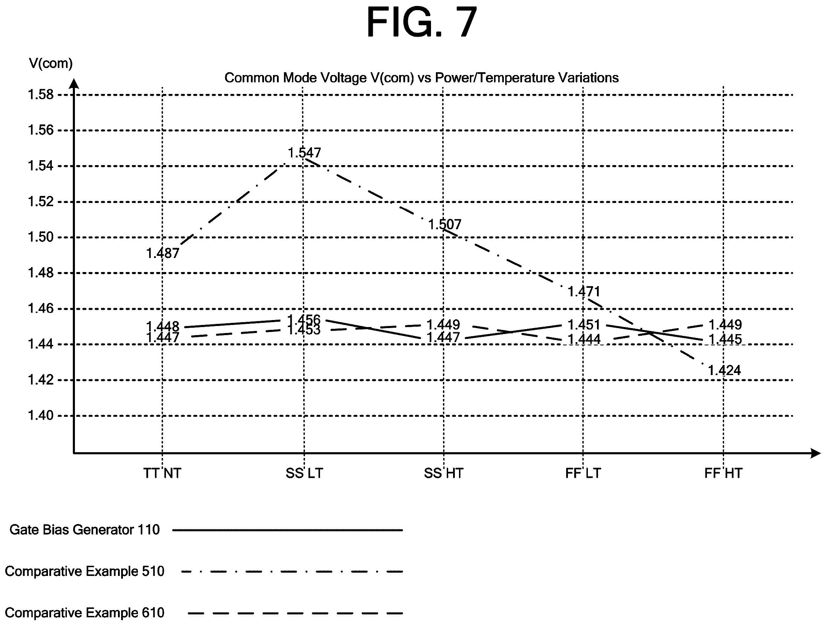

Turning now to FIGS. 7, 8 and 9, comparisons regarding the effectiveness of techniques for the biasing output transistors QP27, QP28 of drive circuit 123 are illustrated. Evaluation metrics may include the variation of the common mode voltages Vcom(+), Vcom(-), collectively referred to as "V(com)."

Referring to FIG. 7, a comparison between common mode voltage V(com) and process/temperature variations is illustrated. The vertical axis of the chart in FIG. 7 represents the common mode voltage V(com). The codes displayed on the horizontal of the chart in FIG. 7 describe simulation scenarios that account for process (P) variations that may occur during semiconductor fabrication of an example High-Swing Serial-Link Transmitter 100 and for temperature (T) variations during operation of the example High-Swing Serial-Link Transmitter 100.

Process codes in FIG. 7 may include typical-typical (TT) for nominal transistor performance, slow-slow (SS) for slow NMOS and PMOS performance, fast-fast (FF) for fast NMOS and PMOS performance, fast-slow (FS) for fast NMOS and slow PMOS performance, and slow-fast (SF) for slow NMOS and fast PMOS performance. Temperature codes may include nominal temperature (NT) for room temperature (~25°C), low temperature (LT) for extreme cold (e.g., -40°C), and high temperature (HT) for elevated heat (e.g., 125°C). These codes may be blended to produce combinations such as TT NT (typical process, nominal temperature), SS LT (slow process, low temperature), FF HT (fast process, high temperature), and SF NT (slow NMOS, fast PMOS at nominal temperature).

In the comparison of FIG. 7, the dot-dashed line representing data points for gate bias generator comparative example 510 demonstrates an absence of process/temperature tracking as evidenced by a significant variation in the common mode voltage V(com). The dashed line representing data points for gate bias generator comparative example 610 and the solid line representing data points for gate bias generator 110 both demonstrate similarly effective process/temperature tracking, resulting in improvement linearity across variations in the manufacturing processes and operating temperatures.

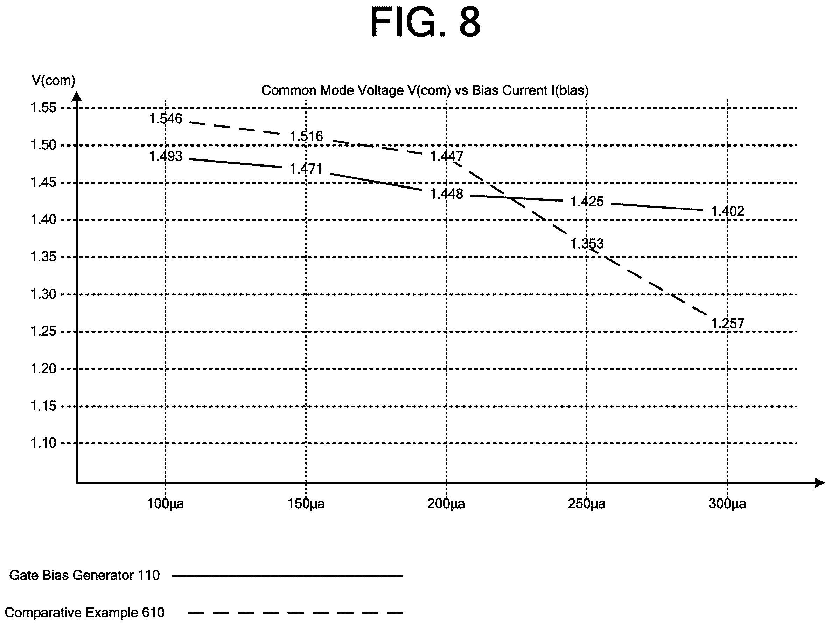

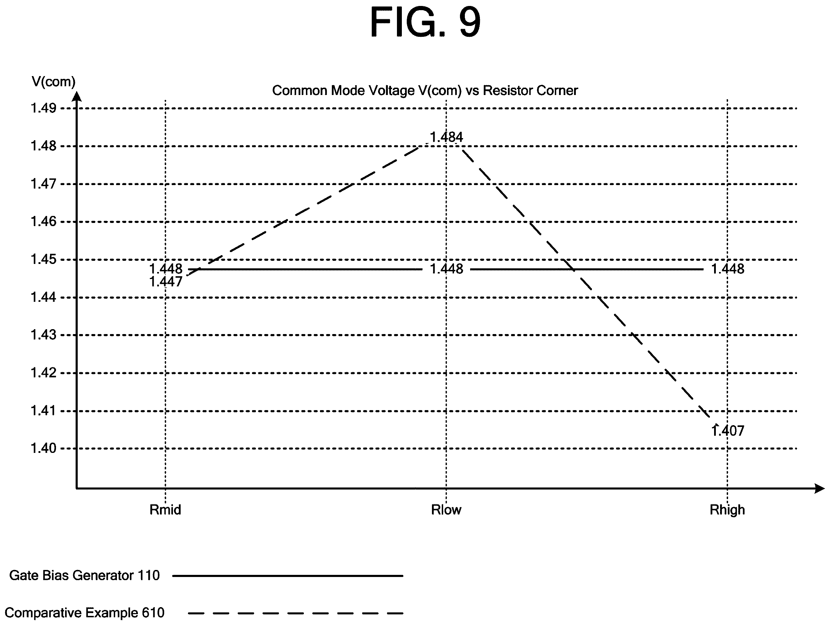

A comparison between common mode voltage V(com) and bias current I(bias) is illustrated in FIG. 8. In FIG. 9, a comparison between common mode voltage V(com) and resistor corner is illustrated in FIG. 9. The Rlow, Rmid, and Rhigh resistor corners in FIG. 9 represent the minimum (Rlow), nominal (Rmid), and maximum (Rhigh) resistance values of a resistor due to manufacturing process and temperature variations. The Rlow, Rmid, and Rhigh resistor corners indicate circuit reliability and performance across worst-case, typical, and best-case resistance variations due to differences in manufacturing processes and temperatures. Comparing the dashed line representing data points for gate bias generator comparative example 610 with the solid line representing data points for gate bias generator 110, FIGS. 8 and 9 demonstrate gate bias generator 110 being less sensitive to the resistor corner than gate bias generator comparative example 610 while also being far less influenced by the value of bias current I(bias).

As demonstrated by the comparisons in FIGS. 7, 8 and 9, gate bias generator 110 is superior to both gate bias generator comparative example 510 and gate bias generator comparative example 610. Thus, gate bias generator 110 may eliminate the drawbacks of the comparative examples by being insensitive to any variation in process and temperature corners, insensitive to insensitive to any variation in resistor corners and insensitive to insensitive to any variation in the bias current I(bias).

In some configurations, transistors QP21, QP22, QN21, QN22 may exist in the same block of an integrated circuit chip. In those instances, a mismatch between sink current I(sink) and drive current I(drive), if any, may depend only on the current mirror accuracy of transistors QP21, QP22, QN21, QN22. As a consequence, the common mode voltages Vcom(+), Vcom(-) may happen to be insensitive to any fluctuation in the bias current I(bias).

Those skilled in the art will also appreciate the arrangement or interconnection of components such as "coupled," "connected," "on," "under," or similar wording allows for indirect connections, or intervening components or layers.

Certain operations of methods according to the technology, or of systems executing those methods, may be represented schematically in the figures or otherwise discussed herein. Unless otherwise specified or limited, representation in the figures of particular operations in particular spatial order may not necessarily require those operations to be executed in a particular sequence corresponding to the particular spatial order. Correspondingly, certain operations represented in the figures, or otherwise disclosed herein, may be executed in different orders than are expressly illustrated or described, as appropriate for particular examples of the technology. Further, in some examples, certain operations may be executed in parallel or partially in parallel, including by dedicated parallel processing devices, or separate computing devices configured to interoperate as part of a large system.

As used herein, unless otherwise limited or defined, "or" indicates a non-exclusive list of components or operations that may be present in any variety of combinations, rather than an exclusive list of components that may be present only as alternatives to each other. For example, a list of "A, B, or C" indicates options of: A; B; C; A and B; A and C; B and C; and A, B, and C.

Correspondingly, the term "or" as used herein is intended to indicate exclusive alternatives only when preceded by terms of exclusivity, such as, e.g., "either," "only one of," or "exactly one of." Further, a list preceded by "one or more" (and variations thereon) and including "or" to separate listed elements indicates options of one or more of any or all of the listed elements.

For example, the phrases "one or more of A, B, or C" and "at least one of A, B, or C" indicate options of: one or more A; one or more B; one or more C; one or more A and one or more B; one or more B and one or more C; one or more A and one or more C; and one or more of each of A, B, and C.

Similarly, a list preceded by "a plurality of" (and variations thereon) and including "or" to separate listed elements indicates options of multiple instances of any or all of the listed elements. For example, the phrases "a plurality of A, B, or C" and "two or more of A, B, or C" indicate options of: A and B; B and C; A and C; and A, B, and C.

In general, the term "or" as used herein only indicates exclusive alternatives (e.g., "one or the other but not both") when preceded by terms of exclusivity, such as, e.g., "either," "only one of," or "exactly one of."

Any mark, if referenced herein, may be common law or registered trademarks of third parties affiliated or unaffiliated with the applicant or the assignee. Use of these marks is by way of example and shall not be construed as descriptive or to limit the scope of disclosed or claimed embodiments to material associated only with such marks.

The articles "a," "an," and "the" are intended to include the plural forms as well, unless the context clearly indicates otherwise.

The terms "comprises," "includes," and "has" specify the presence of stated features, numbers, operations, members, elements, and/or combinations thereof, but do not preclude the presence or addition of one or more other features, numbers, operations, members, elements, and/or combinations thereof.

Throughout the application, ordinal numbers (e.g., first, second, third, etc.) may be used as an adjective for an element (i.e., any noun in the application).

Although terms such as "first," "second," and "third" may be used herein to describe various members, components, regions, layers, or sections, these members, components, regions, layers, or sections are not to be limited by these terms.

Rather, these terms are only used to distinguish one member, component, region, layer, or section from another member, component, region, layer, or section.

The use of ordinal numbers is not to imply or create any particular ordering of the elements nor to limit any element to being only a single element unless expressly disclosed, such as by the use of the terms "before," "after," "single," and other such terminology.

Rather, the use of ordinal numbers is to distinguish between the elements.

By way of an example, a first element is distinct from a second element, and the first element may encompass more than one element and succeed (or precede) the second element in an ordering of elements.

Thus, a first member, component, region, layer, or section referred to in examples described herein may also be referred to as a second member, component, region, layer, or section without departing from the teachings of the examples.

**Claims**

1. A circuit comprising:

   a first resistor between a voltage rail and a drive interconnect, the drive interconnect and the voltage rail being electrically connected to the first resistor;
   a second resistor between the drive interconnect and ground, ground and the drive interconnect being electrically connected to the second resistor;
   a current source between the voltage rail and the drive interconnect, the drive interconnect and the voltage rail being electrically connected to the current source; and
   a transistor between the drive interconnect and a sink interconnect, the drive interconnect and the sink interconnect being electrically connected to the transistor.

2. The circuit according to claim 1, further comprising:
   a current sink between the sink interconnect and ground, ground and the sink interconnect being electrically connected to the current sink.

3. The circuit according to claim 2, wherein
   the current sink is electrically connected directly to the voltage rail.

4. The circuit according to claim 2 or 3, wherein
   the current sink is configured to pull, from the sink interconnect, a sink current to ground.

5. The circuit according to any one of the claims 2 to 4, wherein
   the current sink is between a reference interconnect and ground, the reference interconnect being electrically connected to the current sink.

6. The circuit according to claim 5, wherein
   the current source is between the voltage rail and the reference interconnect, the reference interconnect being electrically connected to the current source.

7. The circuit according to any one of the claims 2 to 6, wherein
   the transistor is a diode-connected transistor.

8. The circuit according to any one of the claims 2 to 7, wherein
   a drain and gate of the transistor are shorted together.

9. The circuit according to any one of the claims 2 to 8, wherein
   the current source is configured to push, from the voltage rail, a drive current onto the drive interconnect.

10. The circuit according to any one of the claims 2 to 9, wherein
    the current source is configured to mirror a reference current to produce a drive current.

11. The circuit according to claim 10, wherein
    the current source is configured to produce the drive current by replicating the reference current:
    or wherein
    the current source is configured to produce the drive current by scaling the reference current.

12. A transmitter comprising:

    a gate bias generator, the gate bias generator comprising:

a current source between a voltage rail and a drive interconnect, the drive interconnect and the voltage rail being electrically connected to the current source,
a diode-connected transistor between the drive interconnect and a sink interconnect, the diode-connected transistor being electrically connected to the drive interconnect and the sink interconnect, and
a current sink between the sink interconnect and ground, ground and the sink interconnect being electrically connected to the current sink; and

an output driver, the output driver comprising:
an output transistor electrically connected in series with a cascode transistor and ground, a gate of the diode-connected transistor being electrically connected directly to a gate of the output transistor.

13. The transmitter according to claim 12, further comprising at least one of the following features:

(A) the transmitter further comprises

a first resistor between the voltage rail and the drive interconnect, the drive interconnect and the voltage rail being electrically connected to the first resistor, and
a second resistor between the drive interconnect and ground, ground and the drive interconnect being electrically connected to the second resistor;

(B) a drain and gate of the diode-connected transistor are shorted together;
(C) the output transistor and the diode-connected transistor are of a same conductivity-type; and
(D) the current sink is electrically connected directly to the voltage rail.

14. The transmitter according to claim 12 or 13, wherein
the current sink is configured to pull, from the sink interconnect, a sink current to ground.

15. The transmitter according to any one of the claims 12 to 14, wherein

the current sink is between a reference interconnect and ground, the reference interconnect being electrically connected to the current sink;
wherein in particular
the current source is between the voltage rail and the reference interconnect, the reference interconnect being electrically connected to the current source.

# FIG. 1

High-Swing Serial-Link Transmitter **100**

Gate Bias Generator **110**

Voltage Rail **130**

enable 122(1)-(N)

Voltage Rail 130

Unit Cells **121(1)-(N)**

Vcom(+)    Vcom(-)

V(bias)

TX(+)    Drive Circuit **123**    TX(-)

Output Driver **120**

EP 4 765 631 A1

# FIG. 2

EP 4 765 631 A1

# FIG. 3

# FIG. 4

# FIG. 5

EP 4 765 631 A1

# FIG. 6

# FIG. 7

V(com)

Common Mode Voltage V(com) vs Power/Temperature Variations

Gate Bias Generator 110 ————————

Comparative Example 510 — · — · — · — · — · —

Comparative Example 610 — — — — — — —

# FIG. 8

Common Mode Voltage V(com) vs Bias Current I(bias)

V(com)

1.55 — 1.546
1.50 — 1.516
1.493 — 1.447
1.45 — 1.471
1.448 — 1.425 — 1.402
1.40
1.353
1.35
1.30
1.257
1.25
1.20
1.15
1.10

100μa    150μa    200μa    250μa    300μa

Gate Bias Generator 110 ——————————

Comparative Example 610 — — — — — — —

EP 4 765 631 A1

# FIG. 9

Common Mode Voltage V(com) vs Resistor Corner

Gate Bias Generator 110 ——————————

Comparative Example 610 — — — — — — — —

EP 4 765 631 A1

Europäisches
Patentamt

European
Patent Office

Office européen
des brevets

# EUROPEAN SEARCH REPORT

**Application Number**

EP 25 22 4372

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/036340 A1 (YOSHIMASU TOSHIHIKO [JP] ET AL) 30 January 2020 (2020-01-30) | 1,2,4,5, 9,12-15 | INV. H03F1/30 |
| A | * paragraphs [0002] - [0131]; figures 1-9 * ----- | 3,6-8, 10,11 | H03F3/45 H03F1/02 G05F3/26 |
| A | US 2004/046599 A1 (ISHIDA SHINJI [JP] ET AL) 11 March 2004 (2004-03-11) * paragraphs [0002] - [0068]; figures 1-7 * ----- | 1-15 | H03F1/22 H03F3/19 |
| A | US 2023/283238 A1 (KLAREN JONATHAN JAMES [US] ET AL) 7 September 2023 (2023-09-07) * paragraphs [0003] - [0063]; figures 1-8 * ----- | 1-15 | |

**TECHNICAL FIELDS SEARCHED (IPC)**

H03F
G05F

The present search report has been drawn up for all claims

| Place of search | Date of completion of the search | Examiner |
|---|---|---|
| The Hague | 15 April 2026 | Fedi, Giulio |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

.......................................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 22 4372

This annex lists the patent family members relating to the patent documents cited in the above-mentioned European search report.
The members are as contained in the European Patent Office EDP file on
The European Patent Office is in no way liable for these particulars which are merely given for the purpose of information.

15-04-2026

| Patent document cited in search report | Publication date | Patent family member(s) | | Publication date |
|---|---|---|---|---|
| US 2020036340 A1 | 30-01-2020 | NONE | | |
| US 2004046599 A1 | 11-03-2004 | JP | 2003347852 A | 05-12-2003 |
| | | US | 2004046599 A1 | 11-03-2004 |
| US 2023283238 A1 | 07-09-2023 | US | 2020036341 A1 | 30-01-2020 |
| | | US | 2020244226 A1 | 30-07-2020 |
| | | US | 2021281220 A1 | 09-09-2021 |
| | | US | 2023283238 A1 | 07-09-2023 |
| | | US | 2024429868 A1 | 26-12-2024 |

EPO FORM P0459

For more details about this annex : see Official Journal of the European Patent Office, No. 12/82